# EUROPEAN PATENT APPLICATION

(11) **EP 2 221 586 A1**
(43) Date of publication of application: **25.08.2010**
(21) Application number: 09250402.6
(22) Date of filing: 13.02.2009
(51) Int. Cl.: G01D 4/00, G01R 11/56

(54) **Electric power connection**

(71) Applicant: BRITISH TELECOMMUNICATIONS public limited company, London EC1A 7AJ (GB)
(72) Inventor: The designation of the inventor has not yet been filed
(74) Representative: Lidbetter, Timothy Guy Edwin

(57) **Abstract**

An electric plug for connection to an electrically powered appliance incorporates an addressable power line telecommunications (PLT) unit 15 which extracts data addressed to the device from the power line 1 and transmits data onto the power line for transmission to other networked devices.

A measurement unit 12 measures the power drawn through the device by the appliance connected to the plug, and these measurements are transmitted through the communications unit 1 5 to a central monitoring unit, which may be a personal computer also connected to wiring using a PLT modem. A control unit 13 can also be inserted in the connection 1, 5, responsive to commands received through the communications unit 15 to turn the current supplied to the appliance on and off. A configuration processor 10 allows the device to be configured remotely through the PLT network from a personal computer or other central controlling device.

## Description

This invention relates to electrical power connections of the type used to supply power from a mains wiring system to an electrical appliance.

As energy conservation becomes of increasing concern to the general public, devices are coming on to the market which monitor and display to the user the current or recent electricity consumption of a user. This is usually done by providing a display of the output of the electricity meter for the premises. However, this only measures the overall consumption of the premises, and not the contribution made by individual appliances. It would be possible to provide monitoring devices for each individual device, but it would be convenient if this information could be provided at a single location. It would also be convenient to be able to control the supply to domestic appliances from a central location, either manually or in accordance with a predetermined programme.

The present invention provides a means for providing such information and control functions.

The present invention provides an electric power connection device for connection to an electricity supply to deliver electrical power to an appliance, the connection device having means for monitoring or controlling the power delivered to the appliance, and an addressable communication unit for exchanging data with other communications devices in a local network.

In the preferred embodiment the device is a plug for fitting to a domestic appliance, although the invention may instead be applied to a wall socket for connection to the mains supply. The plug is easier for a user to install, and its address can be associated in the processor of the hub unit with a specified device. Installation in all the sockets of the premises would ensure that all usage is accounted for. In one embodiment the device is embodied in a unit suitable for installation by modification of a conventional electric plug. This modification may be the replacement of a conventional fuse cartridge with a similarly-dimensioned cartridge incorporating the invention.

The local communications network may be a wireless or Ethernet system, but is preferably a power line telecommunications system (PLT). Such systems carry data over the internal wiring system of a building, using special transceivers connected to the mains wiring through the electric sockets. Generally this can be done with little or no modification to the house wiring itself.

The individual connector may interact with the power supply by monitoring the current drawn by the appliance and reporting this data over the communications network to an application running on another device, such as a personal computer or a communications hub. It may also be responsive to inputs from elsewhere in the communications network to control the power supply to the device, for example by switching the power supply on or off. Such arrangements may be responsive to outside influences such as temperature, or pre-programmed, for example using a timer.

The device may have provision for configuration, either by an input device incorporated in the device or by commands transmitted over the data network, to identify the appliance to which it is attached. It may also provide a visual output, for example to indicate whether power is currently being drawn through it.

The invention is intended for co-operation with a communications device having a communications interface for communication through the local network with one or more such connectors

An embodiment of the invention will now be described by way of example with reference to the drawings, in which:
Figures 1 and 2 are schematic depictions of a typical conventional domestic electric plug
Figure 3 is a schematic depiction of a plug according to the invention
Figure 4 is a schematic depiction of a local network hub device for coordinating the operation of one or more devices of the type shown in Figure 3.

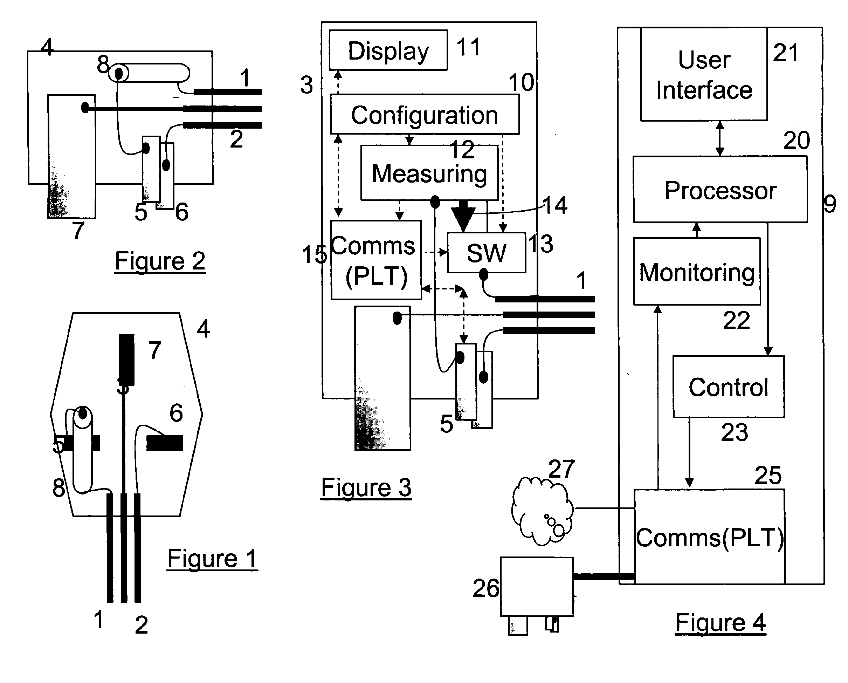

Figures 1 and 2 show respectively a cutaway plan and elevation of a conventional three-pin electric plug, connected to an appliance (not shown) by three wires: live (1) , neutral (2) and earth (or "ground") (3). Within the body 4 of the plug each wire is connected to a respective conductive pin (5, 6, 7) for engagement with a terminal in a complementary socket. The sizes and relative positions of the pins are standardised, but different standards apply from one country to another and in some the earth connection is omitted. In some standards an overcurrent protection device (fuse) 8 is connected in series between the live wire 1 and live pin 5. Other systems provide similar protection in the house wiring rather than in the plug itself.

Figure 3 depicts an electric plug in accordance with the invention. It may be possible to modify an existing plug by installing within it a unit having the required functionality. This would make installation easier as most of the wiring in the plug can be undisturbed. It may be necessary to replace part of the housing if, as represented in Figure 3, the modified plug is significantly larger than the conventional plug. However, this need not be the case if the additional functionality can be incorporated within the existing housing.

This additional functionality comprises five basic functions. These are depicted as separate units but it will be appreciated that they may all be embodied on a single chip or other electronic device.

The plug incorporates an addressable power line telecommunications (PLT) unit 15 which extracts data addressed to the device from the power line 1 and transmits data onto the power line for transmission to other networked devices. Other means of communication are possible, such as a wireless network or wired connections such as Ethernet, but the PLT system is preferred as it is more convenient, requiring no additional connections. The communications protocol may be any existing system, such as IPv4 or IPv6 (Internet Protocol versions 4 and 6)

In Figure 3 power connections are shown in full lines and data connections in dotted lines.

A configuration processor 10 is provided to receive inputs through the communications unit 15 from a co-operating controlling device such as the network hub 9 depicted in Figure 4. This allows the other functions, which will shortly be described, to be configured according to the appliance to which the plug is attached. For example a device may be set to operate at a particular time, or in response to a predetermined ambient temperature. The configuration processor 10 may have provision to allow manual input, but the dimensions of a typical plug, and the location of a typical domestic socket into which the plug is likely to be connected, make it more convenient to configure the device remotely through the PLT network from a personal computer or other central controlling device such as the network hub 9 of Figure 4.

A display unit 11 may be provided to indicate to the user whether the appliance is currently drawing power, or other information such as the network address of the device.

A measuring unit 12 is depicted for measuring power consumption. Assuming that the supply voltage is constant, this can be a simple measurement of the current flowing through the connection 1, 5. The measurements are transmitted through the communications unit 15 to the hub. A control unit 13 (depicted as a simple switch) is also inserted in the connection 1, 5. This is controlled by the commands received through the communications unit 15 to turn the current supplied to the appliance on and off. The communications unit 15 must of course be connected to the electricity supply through the pins 5, 6 independently of the switch 13, so that commands can be delivered to it whether the appliance is receiving power or not.

It will be noted that the overcurrent device 8 of Figure 1 is not depicted in the plug of Figure 3. The function of an overcurrent device may instead be performed by appropriate configuration of the measurement function 12 and switching function 13 to provide an overcurrent protection signal 14. If the functions can be suitably miniaturised, it may be possible to incorporate most of the required functions 10, 12, 13, 15 in a unit dimensioned to correspond to a conventional fuse cartridge 8 (Figures 1, 2) thus allowing the invention to be incorporated in a conventional plug by simply replacing the fuse 8 with such a unit.

The device depicted in Figure 3, together with any others installed on the premises, each have their own IP address and exchange data with a communications hub which receives data relating to the power consumption through each device, and can transmit control signals to reconfigure the devices or to control their operation.

The hub 9 has a connection 16 to the power supply (which may be a conventional plug as shown in Figures 1 and 2) to which is connected a PLT modem 25, which exchanges data with other PLT-equipped devices, including the plug depicted in Figure 3. As already discussed, other communications media, such as Ethernet or wireless, may be used and the hub may be equipped to communicate using more than one of them. An external communications connection 27, for example to a telephone line, may be provided to allow the user to connect to a public data network such as the Internet. A monitoring unit 22 receives inputs from the communications unit 25 for example from the measuring unit 12 in the plug of Figure 3 and a control unit 23 provides outputs through the communications unit 25 for example to control the configuration unit 10 and switch 13 in the plug of Figure 3. These functions are all mediated through a central processor 20. A user interface 21 is provided through which a user can control the operation of the processor 20, and through it the rest of the system and receive outputs for display of, for example, current or recent power consumption.

## Claims

1. An electric power connection device for connection to an electricity supply to deliver electrical power to an appliance, the connection device having means for monitoring or controlling the power delivered to the appliance, and an addressable communications unit for exchanging data with other communications devices in a local network.

2. An electric power connection device according to claim 1, embodied as a wall socket for connection to a power supply and for co-operation with a complementary plug for connection to an electrically powered appliance.

3. An electric power connection device according to claim 1, embodied as a plug for fitting to an electrically powered appliance and for co-operation with a complementary socket for connection to a mains electricity supply.

4. An electric power connection device according to claim 1, embodied in a unit suitable for installation by modification of a conventional electric plug.

5. An electric power connection device according to claim 4, embodied to be dimensioned to replace a conventional fuse cartridge.

6. An electric power connection device according to any preceding claim, wherein the communications unit is a power line telecommunications system.

7. An electric power connection device according to any preceding claim, comprising a monitoring unit for measuring the current drawn by the appliance.

8. An electric power connection device according to any preceding claim, comprising a control unit responsive to signals received through the communications unit to control the power supply to the device.

9. An electric power connection device according to any preceding claim, comprising a configuration unit to generate an identification signal for transmission by he communications unit.
